# EUROPEAN PATENT SPECIFICATION

(11) **EP 0 436 943 B1**
(45) Date of publication and mention of the grant of the patent: **15.05.1996**
(21) Application number: 90125683.4
(22) Date of filing: 28.12.1990
(51) Int. Cl.: H01R 23/70

(54) **Improved card edge connector**
Verbesserter Leiterplattenrandverbinder
Connecteur amélioré de bordure de carte de circuit

(30) Priority: 10.01.1990 US 458071; 05.10.1990 US 593186
(43) Date of publication of application: 17.07.1991
(73) Proprietor: THE WHITAKER CORPORATION, Wilmington, Delaware 19808 (US)
(72) Inventor: Pickles, Charles Sands, Hummelstown, Pennsylvania 17036 (US); Sucheski, Matthew Michael, Harrisburg, Pennsylvania 17111 (US); Thumma, Mark Richard, Oberlin, Pennsylvania 17113 (US)
(74) Representative: Klunker . Schmitt-Nilson . Hirsch

(56) References cited:
- US-A- 3 399 372
- US-A- 4 095 866
- US-A- 4 613 193
- US-A- 4 659 155

## Description

The present invention is related to card edge connectors and more particularly to high-speed card edge connectors. Still more precisely speaking, the present invention is related to an electrical connector for use with a circuit card.

The needs of today's electronic industry require higher speed electronic equipment such as computers and the like. Since many of the electrical interconnections within this type of equipment use circuit boards, it is desirable to provide high-speed card edge connectors having a controlled impedance that will essentially match the impedance of the circuit boards. A high-speed connector is one that can pass fast rise time signals without distorting or degrading that rise time. It is desirable, therefore, to control the impedance of the connector to reduce signal reflection caused by changes in impedance in the pathways conducting the digital pulse. Impedance control requires close spacing of ground and signal traces and interconnections. With the closer spacing of the conductors, it is also necessary to prevent cross talk between adjacent conductors.

U.S. Patent 4,659,155 discloses a two-piece daughter board-backplane connector having an internal connector for use with a circuit board having internal ground plane layer. The daughter board element is connected to a multilayer impedance controlled daughter board having internal ground layers and signal conductors on opposed surfaces. The signal contacts on the board are electrically engaged with rows of signal contacts disposed on opposite sides of the daughter board. The ground contacts are mounted between dielectric portions of the connector element and overlap a plurality of signal contacts on a backplane connector element. The ground contacts overlap a plurality of adjacent signal contacts. The daughter board connector includes a plurality of receptacles for receiving pin members on the backplane element. One disadvantage of the above connector is that it is a two-piece assembly that requires a considerable amount of space to accommodate all of the components of the assembly. Furthermore the connector has a number of different parts, which require a number of manufacturing steps to produce the assembly, thereby increasing the cost of the finished product. It is desirable therefore to provide a means for assuring a ground contact closely associated with signal connections in a compact and cost effective one-piece connector.

U.S. Patent 3,399,372 discloses a high density connector package having a plurality of signal and ground contacts arranged in an alternating array such that each signal contact is associated with a ground contact. In the disclosed embodiment, the signal contacts are small wire members and the ground contacts are metal sheet members thereby providing for close stacking of the signal and ground pairs. The disadvantage of the alternating contact type of system is that for signal contacts to be maintained at a given center line spacing, the dimensions of the various internal members of the assembly must be "scaled down" to provide for "double density", that is that two adjacent contacts must be accommodated in the space previously occupied by a single contact member.

It is an object of the invention to provide a one-piece grounded high-speed connector.

It is another object of the invention to provide a high-speed connector that will fit within the same geometric spacing as existing card edge connectors while maintaining the same number of signal contacts on the same centerlines as standard card edge connectors.

It is a further object of the invention to provide a one-piece controlled impedance card edge connector.

It is yet another object of the invention to provide a high speed connector that can remain energized during insertion or withdrawal of a circuit card therefrom.

It is also an object of the invention to provide a cost effective means for making a one-piece high-speed electrical connector.

It is a still further object of the present invention to provide a signal and ground pair at each contact position.

It is an additional object of the invention to provide a short electrical ground or reference path between the daughter board and the mother board or backplane.

Some of the objects and advantages of the invention having been stated, others will appear as the description proceeds when taken in connection with the accompanying drawing.

These objects are solved according to the invention by an electrical connector according to the features of independent claim 1. Dependent claims 2 to 6 exhibit advantages and non-trivial improvements of the subject-matter of independent claim 1.

The card edge connector of the present invention provides an assured ground connection associated with each signal connection and at each location of the signal contact pairs and permits insertion and/or withdrawal of a daughter card from an energized electronic system.

From document **US-A-4,095,866** a high density printed circuit board and edge connector assembly has come to be known. The terminals in an outer row of terminals closest to the edge of the board are connected to printed circuits on inner layers of the multiple layer printed circuit board by plated-through holes or other suitable techniques; and the printed circuits on the outer layer or layers are connected to the inner row of terminals spaced just inside the outer row of terminals. The known circuit board connector is provided with spring contacts which are electrically insulated from one another but which are designated to engage the multiple layer printed circuit board at the position of the first and second rows of terminals. The spring contacts engaging the inner row of terminals of the circuit board are longer in length than those engaging the other row of terminals, and are thus easily deflected so that the printed circuit board may be inserted or removed from the connector without excessive force. When used with a circuit card comprising ground contact means and signal traces, the document US-A-4, 095,866 represents an electrical connector according to the preamble of claim 1.

From document **US-A-3,399,372** a high density connector package has come to be known. A plurality of sheet metal ground contacts are formed in a general U-shape with these contacts having top and bottom contact buttons facing into the opening of the U-shape for top and bottom ground tabs of the printed circuit board wherein these contacts are slotted to provide spring action when mounted by projections in a box-like housing.

The present invention is related to an electrical connector that alleviates the disadvantages and deficiencies of the prior art by providing a means for assuring a ground connection associated with each signal connection at each location of a pair of signal contacts and between the signal contact members of each pair.

In relationship with the present invention an electrical connector for use with circuit boards of the type having ground contact means disposed along the leading edge thereof and signal traces located rearwardly from the ground contact means comprises a dielectric housing member having a plurality of contact locations spaced laterally along a card receiving cavity extending therein, a pair of opposed signal contact members and a discrete ground contact member disposed between the opposed contact members at each contact location of the connector. The signal contact members have contact sections for engaging respective opposed traces on opposite major surfaces of a card inserted therebetween, the contact sections being defined on free ends of cantilevered beams which extend into the cavity and are deflected outwardly by the card upon insertion therebetween. Upon full insertion of the card the contact sections become engaged with the respective contact sections on the circuit board. At each contact location a ground contact member having a first contact section comprising a pair of opposed cantilevered beams also extends into the card receiving cavity. The beams include contact sections thereon engageable with the ground contact means on opposed sides of the card upon full insertion therebetween. The card edge connector of the present invention provides an assured ground connection associated with each signal connection and at each location of the signal contact pairs.

In one embodiment, the invention is related with a connector that provides a means for assuring a ground connection associated with each signal connection at each location of a pair of signal contacts and between the signal contact members of each pair and concomitantly maintains the electrical integrity of an energized electronic system during withdrawal and/or insertion of daughter cards therefrom. The electrical connector of this embodiment is designed for use with circuit boards of the type having ground contact means disposed along the leading edge thereof and signal traces disposed proximate to and spaced vertically and horizontally from the ground contact means. The housing and locations of the respective signal and ground contact members are substantially the same as the previously described embodiment. The essential difference lies in the configuration of the contact sections of the respective contact members that engage the traces on the daughter cards. The contact sections of the signal contact members are defined on raised portions of the free ends of cantilevered beams, which extend into the cavity and are deflected outwardly by the card upon insertion therebetween. The signal contacts are configured so that the respective contact sections are proximate a first side of the respective contact receiving passageway. Upon full insertion of the card the contact sections become engaged with the respective signal contact sections on the circuit board. At each contact location a ground contact member having a first contact section comprising a pair of opposed cantilevered beams also extends into the card receiving cavity. The beams include contact sections thereon engageable with the ground contact means on opposed sides of the card upon full insertion therebetween. The ground contact beams are configured so that the corresponding contact sections lie proximate a second side of the respective contact receiving passageway, thereby spacing the respective contact sections of the associated signal and ground contact members vertically as well as horizontally from each other within each passageway.

### BRIEF DESCRIPTION OF THE DRAWING

FIGURE 1 is an exploded fragmentary perspective view of the connector of the invention mating a daughter board and a backplane;
FIGURE 2 is a perspective view of a pair of signal contact members made in accordance with the invention;
FIGURE 3 is a perspective view of the ground contact member made in accordance with the invention;
FIGURES 4 through 7 are cross-sectional views of the connector of Figure 1 sequentially illustrating the process of inserting the daughter card between the signal and ground contact members of the present invention;
FIGURE 8 is a perspective view of an alternative embodiment for the ground contact member;
FIGURE 9 is a side view of two of the ground contact members of Figure 8 having the corresponding second contact sections of the terminal members extending along side each other for insertion into a common through-hole in the mother board or backplane;
FIGURE 10 illustrates an alternative embodiment of the backplane for use with the alternative terminal member of Figure 8;
FIGURE 11 is an exploded fragmentary perspective view of the connector of the invention mating a daughter board and a backplane;
FIGURE 12 is a perspective view of a pair of signal contact members made in accordance with the invention;
FIGURE 13 is a perspective view of the ground contact member made in accordance with the invention;
FIGURE 14 is a fragmentary enlarged view of the signal and ground contact members illustrating the offset contact surfaces;
FIGURE 15 is a perspective view of two sets of signal and ground contact members removed from the connector housing and illustrating the relative positions of the contact members in adjacent contact receiving passageways;
FIGURE 16 is a cross-sectional view of the connector of Figure 11 illustrating the contact members after full insertion of the daughter card between the signal and ground contact members of the present invention;
FIGURES 16A and 16B are views taken along the lines 16A-16A, 16B-16B, respectively of Figure 16;
FIGURE 17 is an enlarged fragmentary view of one surface of the daughter card illustrating the configuration of the circuitry on the card; and
FIGURE 18 is a perspective view of an alternative embodiment for the ground contact member.

### DETAILED DESCRIPTION OF THE DRAWING

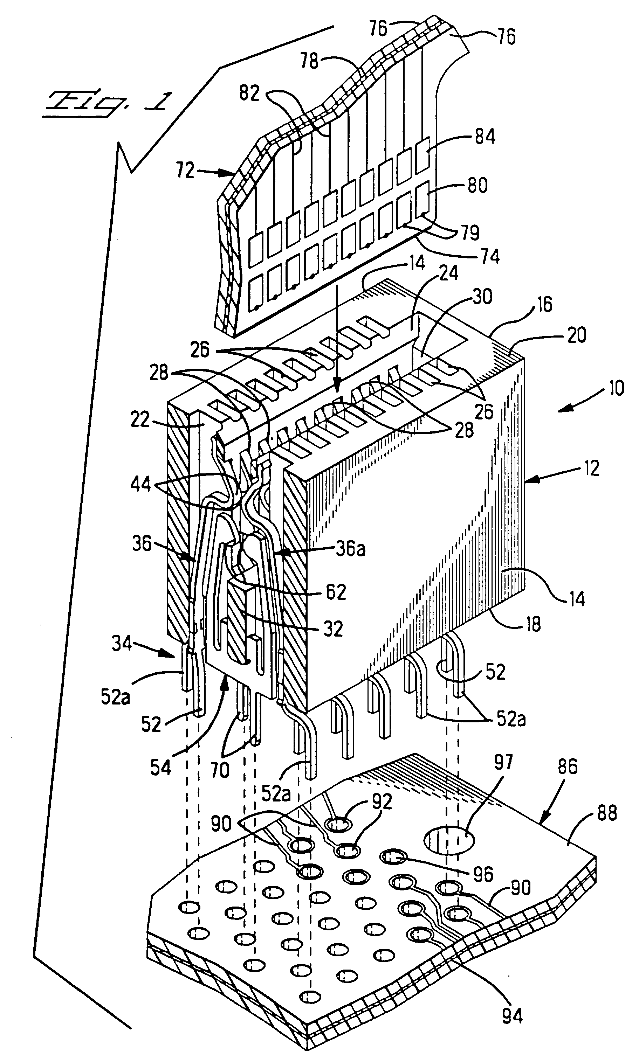

Figure 1 shows an electrical connector 10 comprising a dielectric housing member 12 having opposed arrays of contact receiving passageways 26 extending therethrough, a plurality of contacts 34 disposed in respective passageways 26 and a card receiving cavity 30 extending laterally between the opposed arrays of passageways 26 for receiving a card member 72. Dielectric housing member 12 has opposed side walls 14, end walls 16, mounting face 18 and card receiving face 20. An array of contact receiving passageways 26 is defined along side walls 14 of housing 12 for receiving respective signal contact members 36, 36A and ground contact members 54 therein. Adjacent contact receiving passageways 26 in respective arrays are separated by internal wall portions 22, the inner edges 24 of which define card receiving cavity 30. Respective arrays of signal contact locations 28 extend along the upper part of card receiving cavity 30, a signal location 28 being associated with each one of the contact receiving passageways 26. Housing 12 further includes a lower web or wall 32 extending longitudinally between opposed end walls 16 (only one of which is shown), the upper surface of wall 32 defining the lower end of card receiving cavity 30.

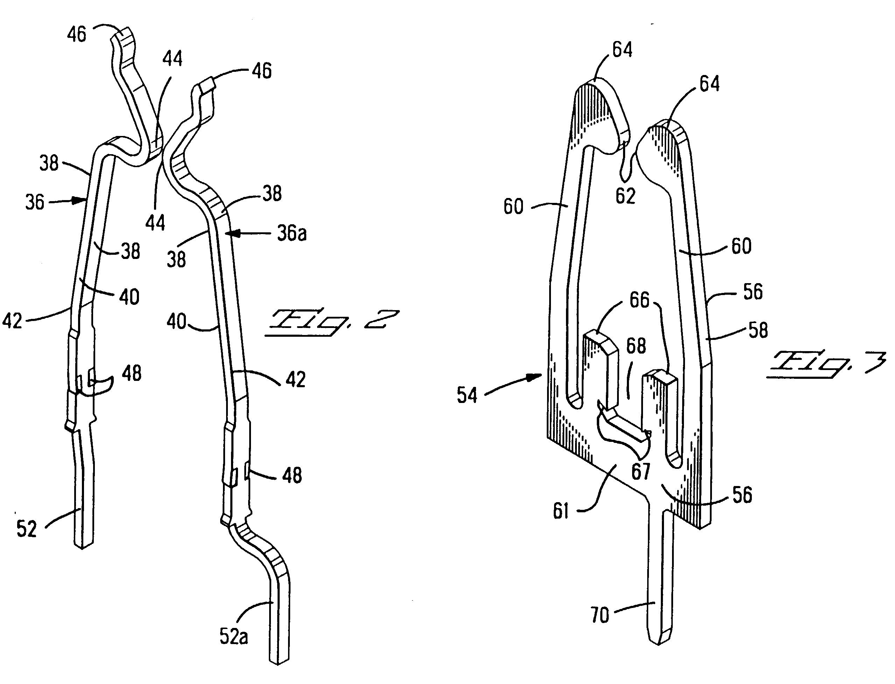

As shown in Figure 1 and Figures 4 through 7 a pair of opposed signal contact members 36, 36a and a single ground contact 54 are disposed within each of the contact receiving cavities 26. As best seen in Figure 2, the opposed pair of signal contact members 36, 36a include cantilevered beam portions 42, each having opposed major surfaces 38 and edges 40. Corresponding first contact sections 44 are adjacent free ends 46 of respective signal contact members 36, 36a. The signal contact members 36,36a further include respective second contact sections 52 and 52a, which extend from respective other ends of signal contact members 36, 36a and extend through the mounting face 18 of the housing 12. For purposes of illustration, the surrounding portions of housing 12 have been eliminated from Figure 2 and the pair of spring contact members 36, 36a are shown in the same prestressed position as the contact members 36, 36a of Figure 1.

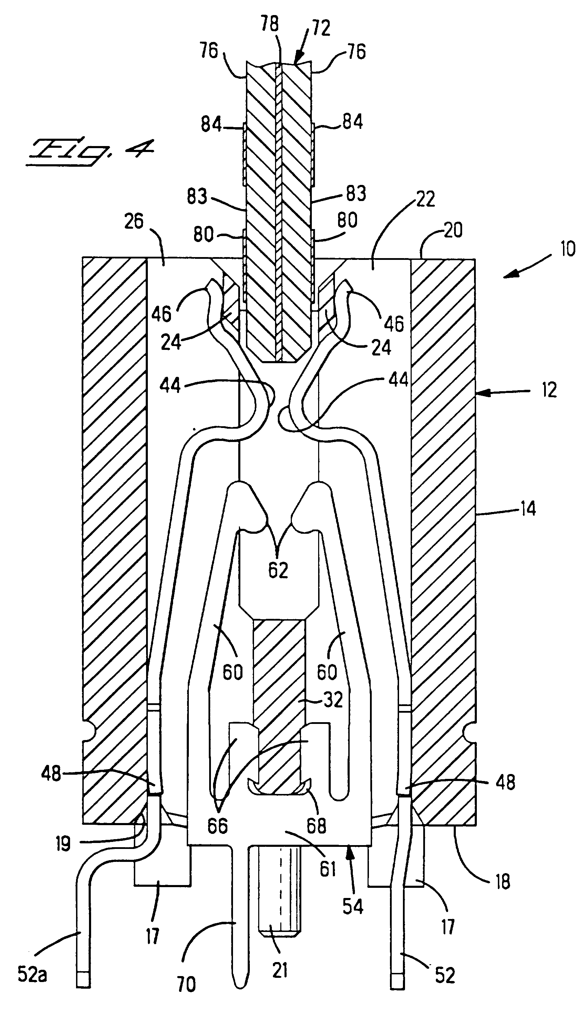

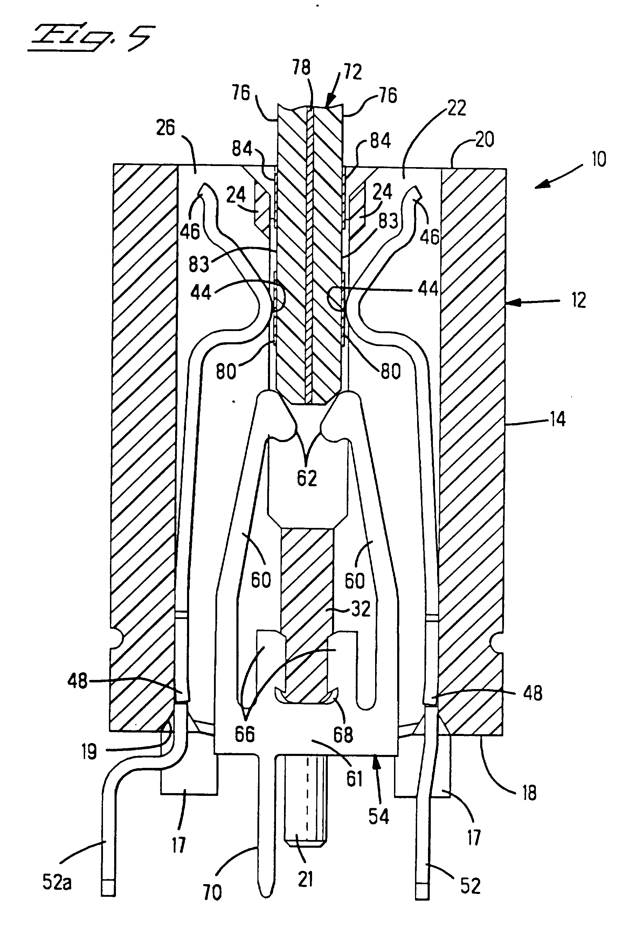

As shown in these Figures, the two styles of signal contact members 36, 36a differ only in the shape of the second contact sections 52, 52a and are arranged alternately in the respective cavities 26 of housing 12 to provide a staggered arrangement of the second contact sections 52, 52a extending from mounting face 18 of housing 12. As best seen in Figure 1, this provides a staggered array of second contact sections 52, 52a for electrically engaging a corresponding staggered array of signal through-holes 92 in backplane 86. The pair of contact members 36, 36a are shown in one arrangement in Figure 1 and in the other arrangement in Figures 4 through 7. Signal contact members 36, 36a further include outwardly extending locking lances 48 adjacent the second contact section 52, 52a, lances 48 being adapted to cooperate with wall portions (not shown) within the housing 12 to secure the signal contact members 36, 36a therein. As shown in Figure 1 and 4 through 7, the free ends 46 of opposed contact beams 42 lie adjacent a portion of the internal wall 24 forming the contact receiving card receiving cavity 30 and are held in a prestressed position thereagainst.

Ground contact member 54 is generally a U-shaped member having opposed major surfaces 56, edges 58 and cantilevered beams 60 extending upwardly from bight section 61. Cantilevered beams 60 have first contact sections 62 at opposed free ends 64 thereof. Ground contact member 54 further includes a pair of projections 66 extending upwardly from bight section 61 and defining slot 68 therebetween. When ground contact member 54 is received in the housing 12 as shown in Figure 1 and Figures 4 through 7, internal wall 32 is received within slot 68 thereby holding ground contact member 54 in position. The arrangement of the signal contact pair and ground contact member in the same contact receiving passageway more typically occupied only by a signal contact pair, enables the centerline spacing of the signal contact members to be maintained while achieving the advantages of the signal-ground contact combination. These advantages are achieved without the need to provide extra contact receiving passageways or affecting the mechanical tolerances within the housing member, as required in those connectors having additional passageways and "scaled-down" contact members. For example, in a high-speed card connector made in accordance with the present invention signal contact pairs and a ground contact member on a approx. 1,255 mm (0.050 inch) centerline spacing will occupy the same geometric space as an existing approx. 1,255 mm (0.050 inch) centerline card edge connector. The contact arrangement of the present invention also facilitates the making of high-speed connectors having signal and contact members on other centerline spacing such as approx. 0,63 mm (0.025 inch) and smaller.

In the embodiment shown in Figure 3, second contact section 70 extends from bight section 61 and is offset from the center thereof. As is seen in Figures 1 and 4 through 7 the ground contact member 54 is placed in housing 12 in one of two positions such that the edge 58 of the ground contact member 54 nearer the second contact section 70 is adjacent signal contact member 36a. The ground contact member 54, therefore, is also reversed in adjacent cavities 26 as best seen in Figure 1 to provide a staggered array of second ground contact sections 70 for insertion into a staggered array of ground through-holes 94 on back plane or mother board 86. Figures 4 through 7 also show housing stand-offs 17, which hold connector 10 away from the surface of mother board 86, thereby facilitating soldering of the contact members, as is known in the art. Figures 4 through 7 also show aligning leg 21, which extends from the mounting face 18 of housing 12 and is inserted in aperture 97 (shown in Figure 1) to align connector 10 in the proper orientation on board 86. Typically there are at least two alignment legs per connector. For purposes of illustrating the invention, the second contact sections 52, 52a of the signal contact members 36, 36a and ground contact member 54 are shown as pin members that are received into respective signal and ground through-holes 92, 96 respectively of a backplane member 86. It is to be understood that the configuration of the second contact section of the respective contact members may have other configurations such as for example socket contacts for receiving pin members.

Electrical connector 10 is designed for use with a daughter card 72 of the type having ground contact means 80 disposed on opposed major surfaces 76 of card 72 and along a leading edge 74 thereof and proximate thereto and signal traces 82 having signal contact means 84 located rearwardly from the ground contact means 80 on opposed major surfaces 76. In high-speed electrical applications, it is desirable to establish and maintain electrically stable reference or ground potential through the system including through the daughter card, connector and the mother board or back plane. In the embodiment shown, card 72 includes ground plane layer 78 disposed between dielectric layers and back plane 86 includes ground plane 94 disposed between dielectric layers. Figure 1 shows the plated via-holes 79 interconnecting ground plane 78 to ground contact means 80 of the surface of card 72.

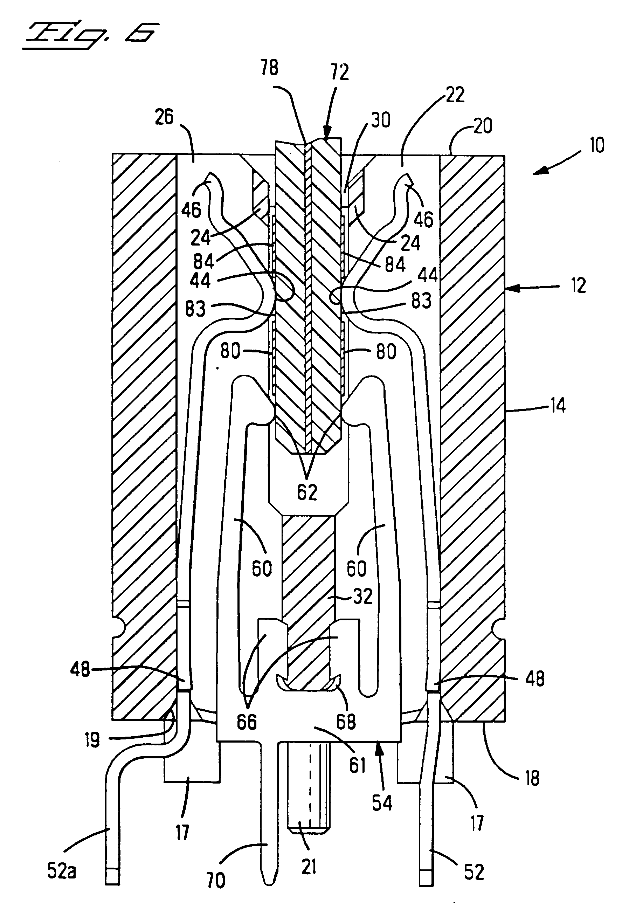

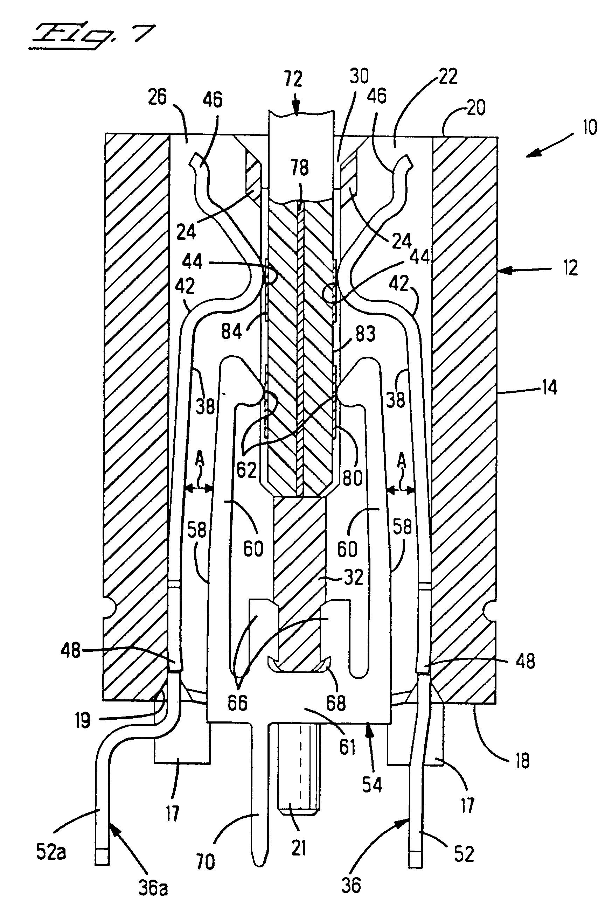

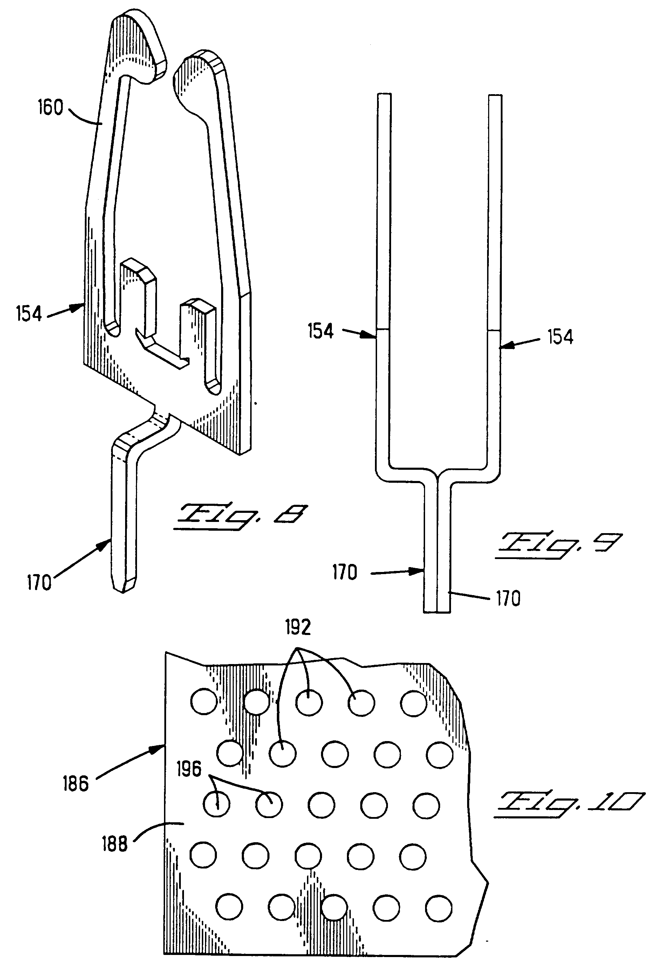

Figures 4 through 7 illustrate the sequential process in electrically connecting the respective signal and ground contact members with corresponding signal and ground contact means on card 72 during insertion of the daughter card 72 into connector 10. As is known in the art, card 72 and housing 12 preferably include keying means (not shown) to accurately align the card 72 in card receiving cavity 30. As shown in Figure 4, the leading edge 74 of card 72 is inserted into card receiving cavity 30 between the signal contact sections 44 of beams 42 causing the beams 42 to deflect outwardly, as card 72 is inserted therebetween. The first contact sections 44 of signal contact member 36, 36a first electrically engage the ground contacts 80 on the board. As shown in Figure 5, as card 72 is further inserted into the card receiving slot 30, the leading edge 74 of card 72 enters the space between the first contact sections 62 of ground contact member 54 deflecting the corresponding beams 60 outwardly as is shown in Figure 6. Figure 6 further illustrates that as the card 72 is moved into card receiving slot 30 the signal and ground contact means 84, 80 on the opposed surfaces 76 of card 72 and the corresponding first signal contact sections 44 and first ground contact sections 62 are sufficiently spaced from each other such that the first contact sections 44 of the signal contact members 36, 36a and the first ground contact section 62 will not simultaneously electrically engage the ground contact means 80 thereby causing a short circuit. Figure 7 shows the electrical connection of the signal contact sections 44 with corresponding signal means 84 and ground contact sections 62 with ground means 80 on the fully inserted board 72.

In making the electrical connector 10 in accordance with the invention, housing 12 is formed from a dielectric material such as for example polyphenylene sulfide, which is readily available from a number of commercial sources. Other suitable materials, as known in the art, may also be used. The signal contact members are stamped and formed to have a preloaded spring rate designed to provide the desired normal force at the respective contact surface when the card 72 is fully engaged in the connector 10. The signal contact members 36, 36a are loaded from the mounting face 18 of the housing 12 and are inserted so that free ends 44 are secured against upper wall 24 portion. The outwardly extending flanges 48 engage a corresponding flange receiving surface (not shown) within the housing to lock the signal contact members 36, 36a within the housing. To facilitate insertion of contact members, mounting face 18 includes lead in surfaces 19. The ground contact member 54 is also inserted from the mounting face 18 of the connector 10 such that the upwardly extending projections 66 are received on opposite sidewalls of lower wall 32. In the preferred embodiment projections 66 have downwardly extending lances 67 which engage lower housing wall 32 to provide a secure fit within the housing 12. Since the signal contact members 36, 36a press against the outside walls 14 of housing 12 and the ground contact member presses against and grips the center wall or web 32, the resultant reactive stresses created in the contact retention region are directed in lines that extend across the connector width, are independent and are not additive. The connector of the present invention, therefore, distributes internal stresses in a optimal manner.

Signal contact members 36 are preferably made from phosphor bronze or other materials having the desired spring characteristics to provide the sufficient normal force. The ground contact member 54 is stamped from a metal having sufficient spring characteristics to provide a desired normal force at the contact mating face thereof, such as phosphor bronze. In accordance with the invention the materials selected and the geometric configuration of the contact members needs to be such that a sufficient normal force is generated at the respective contact areas to assure electrical reliability of the interconnections. Since no preload is formed in the ground contact member, the ground contact member preferably has a higher spring rate than that of the signal terminal member. In the preferred embodiment the geometrical shape of the outside edge of 58 of ground contact member 54 is substantially the same as the shape of the internal major surface of the corresponding signal contact members 36, 36a to provide a substantially constant spacing between the signal and ground contact members. The shape and spacing between the respective members provides a characteristic impedance to each signal and ground contact group. By maintaining the same characteristic impedance at all contact locations throughout the connector the characteristic impedance of the connector as a whole may be controlled. The connector, therefore, can be "custom designed" within a range of tolerances to control the impedance and to substantially match the impedance of the daughter card and mother board.

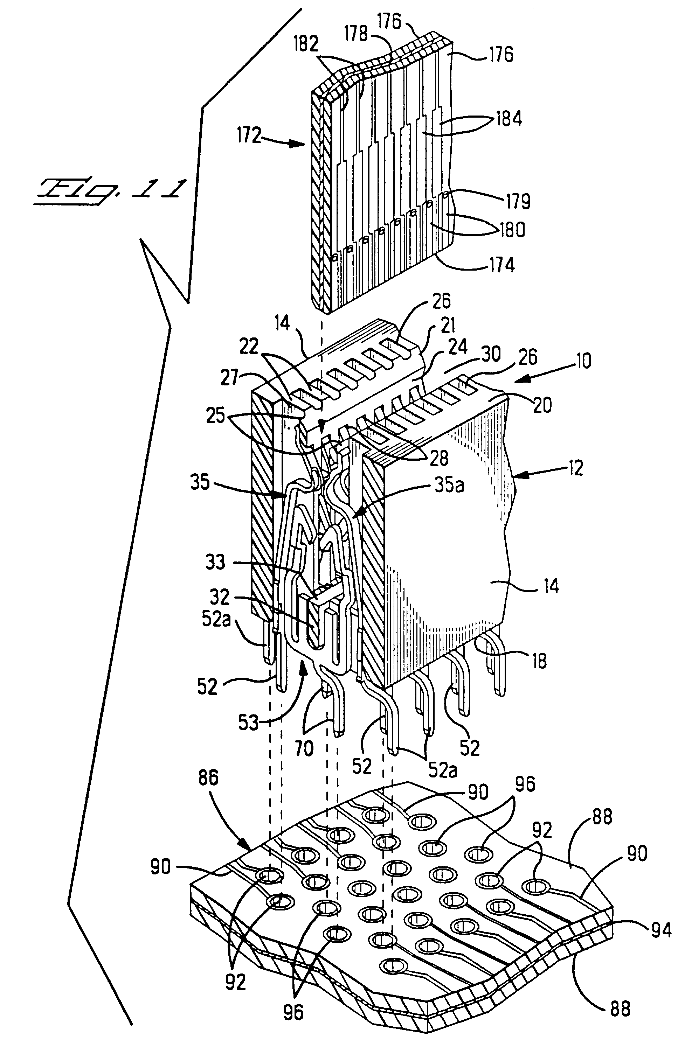

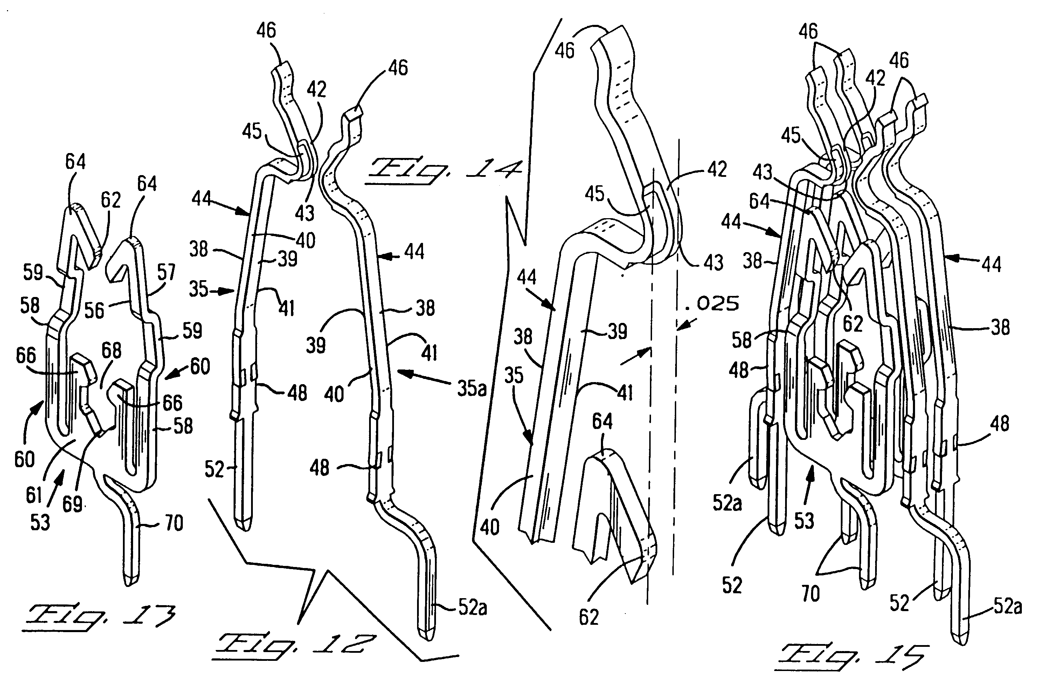

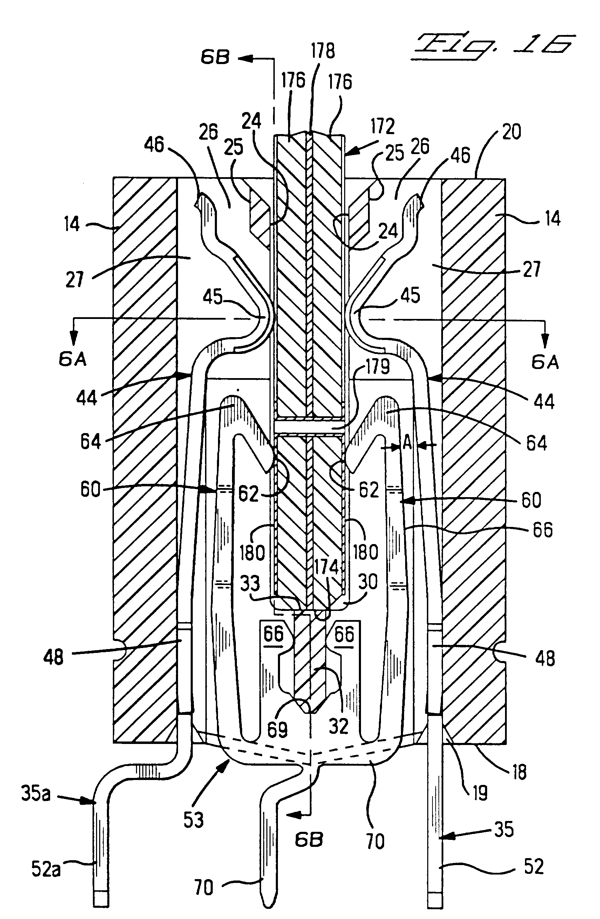

Figure 8 illustrates an alternative embodiment 154 of the ground contact member having a second contact section 170 which is located essentially at the center of the bight portion of the ground contact member 154 and further includes a jog extending upwardly from the plane of the major surface of the contact member 154. This embodiment is designed to be used with the alternative backplane embodiment 186 shown in Figure 10, wherein the ground through-holes 196 are disposed in a single aligned array. The ground contact members 154 are arranged in pairs such that the second contact sections 170 of the respective pairs lie adjacent each other and enter the same ground through-hole 196 thereby reducing the number of holes required in the backplane or circuit board 186.

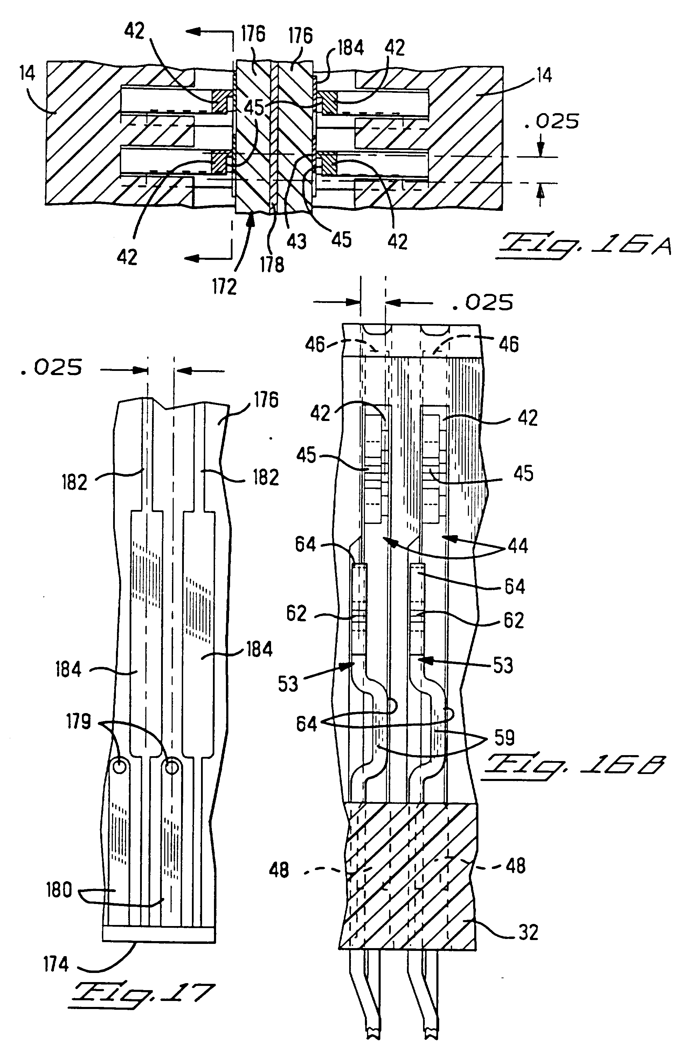

Figure 11 shows an alternative embodiment 110 of the electrical connector comprising a dielectric housing member 12 having opposed arrays of contact receiving passageways 26 extending therethrough, a plurality of contact members 35,35a,53 disposed in respective passageways 26 and a card receiving cavity 30 extending laterally between the opposed arrays of passageways 26 for receiving a card member 172. Since structure of the housing and contact members of connector 110 is substantially the same as that of connector 10, the same numbers will be used wherever applicable.

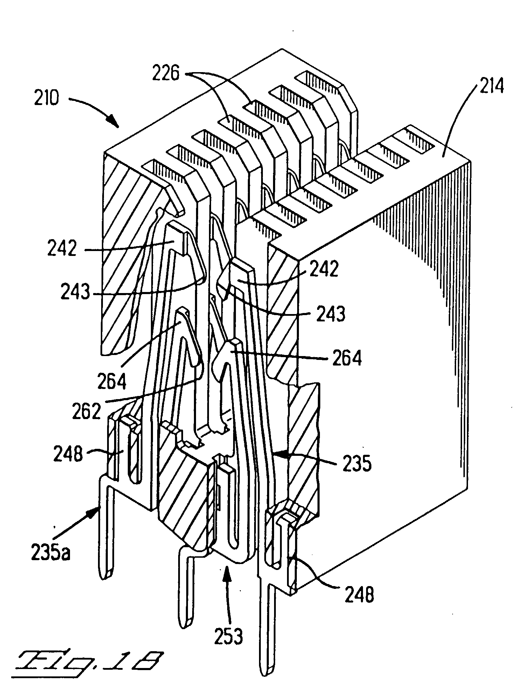

As shown in Figures 11 and 16, a pair of opposed signal contact members 35,35a and a single ground contact 53 are disposed within each of the contact receiving cavities 26. As best seen in Figure 12, in the preferred embodiment, the opposed pair of signal contact members 35,35a are stamped and formed members having opposed major surfaces 38,39 and opposed side edges 40,41. Each signal contact member 35,35a includes first and second contact sections 44,44; 52,52a respectively. Each first signal contact section 44 comprises a cantilevered beam having a configured portion 42 adjacent the free end 46 thereof. As can best be seen in Figures 12 and 14, portion 42 includes a portion 45 having a reduced thickness and portion 43 being substantially the thickness of the stamped member. Since portion 43 is thicker than portion 45, only the surface of 43 will engage the surface of the daughter card thereby defining a respective signal contact surface for engaging a corresponding signal contact 184 on a circuit card 172, as shown in Figure 16A. As can be seen from Figures 12 and 14, the width of portion 43 is approximately one quarter that of the configured portion 45. It is to be understood that the relative width of portions 43 and 45 may be varied to accommodate the geometry of the circuitry on the card. The second contact sections 52 and 52a of signal contact members 35,35a extend from respective other ends thereof and through the mounting face 18 of the housing 12 as previously discussed. For purposes of illustration, the surrounding portions of housing 12 have been eliminated from Figures 12 through 15 and the pair of spring contact members 35,35a are shown in the same prestressed position as the contact members 35,35a of Figure 11. The staggered arrays of contact members are best seen in Figure 15, which illustrates the relative positions of signal and ground contact members from two adjacent contact receiving passageways. Signal contact members 35,35a further include outwardly extending locking means 48 which are adapted to cooperate with wall portions (not shown) within the housing 12 to secure the signal contact members 35,35a therein. As shown in Figures 11 and 16, the free ends 46 of opposed contact beams 44 lie adjacent surface 25 of wall 22 forming the contact receiving card receiving cavity 30 and are held in a prestressed position thereagainst.

As best seen in Figure 13, ground contact member 53 is generally a U-shaped member having opposed major surfaces 56,57, edges 58 and cantilevered beams 60 extending upwardly from bight section 61. Cantilevered beams 60 have first contact sections 62 at opposed free ends 64 thereof. In the preferred embodiment, beams 60 include a formed portion 59 that extends outwardly of the plane of the body and defines a positioning means to keep the contact section 62 proximate the desired sidewall surface 27 of passageway 26, as shown in Figure 11 and to prevent the ground contact member 53 from "skating" between the surfaces 27 of two adjacent sidewalls 22. As shown in Figure 14, the width of ground contact section 62 is essentially one half that of the associated signal contact member 35 and lies proximate side edge 40 of contact member 35. The respective contact surfaces 43,62 of the signal and ground contact members 35,53 are thereby spaced horizontally as well as vertically within the respective passageway 26 of housing 12. Ground contact member 53 further includes a pair of projections 66 extending upwardly from bight section 61 and defining slot 68 having lower surface 69 therebetween. When ground contact member 53 is received in the housing 12 as shown in Figures 11 and 16, internal wall 32 is received within slot 68 thereby holding ground contact member 53 within housing 12 and surface 58 along portion 59 proximate the surface 27 of an internal wall 22, as best seen in Figure 16B.

The horizontally and vertically staggered contact surfaces 43,62 of contact members 35,53 respectively and the configuration of the contact surfaces 180,184 on the circuit card 172 thus enables a circuit card to be inserted in the connector 10 without the signal contact surface 43 engaging the ground contact 180, thereby permitting insertion and withdrawal of a card while the connector 10 remains energized. In Figures 16,16A and 16B, contact surfaces 62 of ground contact member 53 are shown in electrical engagement with corresponding ground contact surfaces 180 of card 172. The associated signal contact surfaces 43 are shown in the background and are more clearly seen by referring to Figures 16A and 16B which are views taken along the lines 16A-16A, 16B-16B respectively of Figure 16, looking down and looking across on the contact receiving passageways 22 with the contact members 35,35a,53 and card 172 therein. As can be seen in Figure 16A, signal contact surface 43 is in electrical engagement with corresponding signal contact surfaces 184 on card 172. Figure 16B shows the rear surfaces 57 of ground contacts 53 against wall 27 of the respective passageways 22.

Electrical connector 110 is designed for use with a daughter card 172 of the type having ground contact means 180 disposed on opposed major surfaces 176 of card 172 and along a leading edge 174 thereof and proximate thereto and signal traces 182 having signal contact means 184 spaced both vertically and horizontally from the ground contact means 180 on opposed major surfaces 176, as shown in Figures 11 and 17. In high-speed electrical applications, it is desirable to establish and maintain electrically stable reference or ground potential through the system including through the daughter card, connector and the mother board or back plane. In the embodiment shown in Figure 11, card 172 includes a single ground plane layer 178 disposed between dielectric layers and back plane 86 includes ground plane 94 disposed between dielectric layers. A single ground plane layer has been shown for purposes of illustration only. It is to be understood that both the card and back plane may include a plurality of dielectric and ground plane layers. Figure 16 shows a plated through hole 179 interconnecting the ground plane 178 to ground contact means 180 of the surface of card 172.

Figure 18 illustrates an alternative embodiment 210 of the connector in which the signal and ground contact members 235,253 are essentially planar members that have been "blanked" from a desired material and have skived contact surfaces 243,262, respectively. The upper portions 242,264 of the respective cantilevered beams are positioned so that the respective contact surfaces are offset from each other in the contact receiving passageway 226. The contact surface of a ground contact member may be formed on a "flag-shaped" portion that extends in a direction away from the associated signal contact member in the same cavity such that the contact surface will engage the ground contact on a circuit card of the type shown in Figures 11 and 17 upon full insertion of the daughter card into the connector. Preferably, the contact surface is dimpled or raised so that it is assuredly offset horizontally from the associated signal contact surfaces. The signal contact, on the other hand, has no flag-shaped extension and will not engage the ground contact as the card is inserted.

It is thought that the card edge connector of the present invention and many of its intendant advantages will be understood form the foregoing description. Changes may be made in the form, construction and arrangement of parts thereof without departing from the scope of the appended claims.

## Claims

1. An electrical connector (10) for use with a circuit card (72) of the type having ground contact means (80) disposed along a leading edge and proximate thereto and signal traces having signal contact means (84) located rearwardly from said ground contact means (80) on each major surface of the circuit card (72), said connector (10) comprising:
a) a dielectric housing member (12) with a mounting face (18) and an opposed card receiving face (16),
b) a card receiving cavity (30) extending into said housing (12) from said card receiving face (16) to a card stop means (32),
c) a plurality of contacts adapted for mating with said card (72) at respective contact locations spaced laterally along said cavity (30) and associated with trace locations along said circuit card (72) received in said cavity (30),
d) ground means having a plurality of ground contact members (54) with a pair of opposed cantilevered beams (60),
e) said plurality of contacts including signal contact members (36, 36a) arranged in opposed pairs along opposite sides of said card receiving cavity (30) at each said contact location and secured in respective contact receiving passageways (26) thereat in communication with that card receiving cavity (30),
f) said signal contact members (36, 36a) having contact sections (44) for engaging respective opposed signal traces on opposite major surfaces of said card (72) upon card insertion therebetween,
g) said contact sections (44) being defined on free ends of cantilevered beams extending into said cavity (30) to be deflected outwardly by said card (72) upon card insertion whereupon said contact sections (44) become engaged with respective contact sections of signal traces (84) upon full card insertion,
h) said signal contact members (36, 36a) having second contact sections (52, 52a) at least exposed along the mounting face (18) of the housing (12) and adapted to be mated with corresponding signal contact means (90) of another electrical article (86),
i) said housing (12) and said signal contact members (36, 36a) secured therein at each said signal contact location being adapted to permit a said ground contact member (54) to be mounted into said housing at each said signal contact location and between ones of a respective said pair of signal contact members (36, 36a) thereat and spaced therefrom,
j) said pairs of opposed cantilevered beams (60) of said ground contact member (54) extending upwardly into respective ones of said contact receiving passageways and into said card receiving cavity (30),
k) said pairs of cantilevered beams (60) being deflectable in the plane of said ground contact members by said card upon insertion thereof into said card receiving cavity (30),
l) said pairs of cantilevered beams (60) including ground contact sections (62) thereon engageable with respective said ground contact means (79) of said card (72) upon full card insertion,
m) said ground contact members (54) including second ground contact sections (70) at said contact locations,
n) said second ground contact sections (70) at least exposed along the mounting face of said housing and engageable with corresponding ground contacts (96) of said electrical article (86);
o) whereby said connector has an assured ground connection associated with each signal connection at each location of said signal contact pairs and between said signal contact members of the respective said pair,
**characterized in that**
p) each said ground contact member (54) being an essentially planar member and including a body section (61) extending from first to second side edges, said pair of opposed cantilevered beams (60) extending upwardly from said body section (61) proximate said first and second side edges.

2. The electrical connector of claim 1 wherein said ground contact sections on said beams of said ground contact members (53) are spaced both vertically and horizontally from the associated first signal contact section; whereby
said first signal contact sections will not engage ground means on a circuit card adapted to have a complementary staggered array of signal and ground contact surfaces when said card is received into said card receiving slot.

3. The connector of claim 1 or 2 wherein after deflection by said circuit card following insertion thereof into said card receiving cavity, the distance between adjacent portions of each pair of associated said signal ground contact beams is a selected substantially constant distance extending continuously therebetween whereby inductance of the connector is lowered.

4. The connector of claim 1, wherein the width of the ground contact body section is greater than the width of the card received in said card receiving cavity.

5. The connector of any preceding claim, wherein said ground contact members are mounted on a center rib (32) extending along the length of the housing.

6. The connector of any preceding claim wherein said housing includes ground contact receiving recesses below said card stop means including passageways into which said ground contact members are inserted from the bottom of said housing.

## Patentansprüche

1. Elektrischer Verbinder (10) zur Verwendung mit einer Schaltungskarte (72) des Typs mit einer Erdungskontakteinrichtung (80), die entlang und in der Nähe eines in Einführrichtung vorderen Rands derselben angeordnet ist, und mit Signalleiterbahnen mit einer Signalkontakteinrichtung (84), die rückwärts von der Erdungskontakteinrichtung (80) auf jeder Hauptfläche der Schaltungskarte (72) angeordnet ist, wobei der Verbinder (10) folgendes aufweist:
a) ein dielektrisches Gehäuseelement (12) mit einer Befestigungsseite (18) und einer gegenüberliegenden Kartenaufnahmeseite (16),
b) einen Kartenaufnahmehohlraum (30), der sich von der Kartenaufnahmeseite (16) bis zu einer Kartenanschlageinrichtung (32) in das Gehäuse (12) hineinerstreckt,
c) eine Vielzahl von Kontakten, die zur Verbindung mit der Karte (72) an jeweiligen Kontaktstellen ausgelegt sind, die in seitlicher Richtung entlang des Hohlraums (30) voneinander beabstandet sind und Leiterbahnen entlang der in dem Hohlraum (30) aufgenommenen Schaltungskarte zugeordnet sind,
d) eine Erdungseinrichtung mit einer Vielzahl von Erdungskontaktelementen (54) mit einem Paar einander gegenüberliegender, freitragender Arme (60),
e) wobei die Vielzahl von Kontakten Signalkontaktelemente (36, 36a) beinhaltet, die in einander gegenüberliegenden Paaren entlang gegenüberliegender Seiten des Kartenaufnahmehohlraums (30) an jeder Kontaktstelle angeordnet sind und dort in jeweiligen Kontaktaufnahmedurchführungen (26) befestigt sind, die mit diesem Kartenaufnahmehohlraum (30) kommunizieren,
f) wobei die Signalkontaktelemente (36, 36a) Kontaktabschnitte (44) aufweisen, um beim Einführen der Karte zwischen diesen an jeweiligen gegenüberliegenden Signalleiterbahnen auf entgegengesetzten Hauptflächen der Karte (72) anzugreifen,
g) wobei die Kontaktabschnitte (44) an freien Enden freitragender Arme definiert sind, die sich in den Hohlraum (30) hineinerstrecken und beim Einführen der Karte (72) durch diese nach außen biegbar sind, wonach die Kontaktabschnitte (44) bei vollständigem Einsetzen der Karte mit den jeweiligen Kontaktabschnitten der Signalleiterbahnen (84) in Eingriff treten,
h) wobei die Signalkontaktelemente (36, 36a) zweite Kontaktabschnitte (52, 52a) aufweisen, die wenigstens entlang der Befestigungsseite (18) des Gehäuses (2) freiliegen und zur Verbindung mit entsprechenden Signalkontakteinrichtungen (90) eines weiteren elektrischen Gegenstands (86) ausgelegt sind,
i) wobei das Gehäuse (12) und die in diesem an jeder Signalkontaktstelle befestigten Signalkontaktelemente (36, 36a) dazu ausgelegt sind, die Anbringung eines Erdungskontaktelements (54) in dem Gehäuse an jeder Signalkontaktstelle sowie zwischen und im Abstand von Signalkontaktelementen (36, 36a) eines jeweiligen Paares von Signalkontaktelementen zu gestatten,
j) wobei die Paare der einander gegenüberliegenden freitragenden Arme (60) des Erdungskontaktelements (54) sich nach oben in jeweilige Kontaktaufnahmeführungen sowie in den Kartenaufnahmehohlraum (30) hineinerstrecken,
k) wobei die Paare der freitragenden Arme (60) durch die Karte beim Einführen derselben in den Kartenaufnahmehohlraum (30) in der Ebene der Erdungskontaktelemente biegbar sind,
l) wobei die Paare der freitragenden Arme (60) daran vorgesehene Erdungskontaktabschnitte (62) beinhalten, die beim vollständigen Einführen der Karte (72) mit den jeweiligen Erdungskontakteinrichtungen (79) der Karte in Eingriff bringbar sind,
m) wobei die Erdungskontaktelemente (54) zweite Erdungskontaktabschnitte (70) an den Kontaktstellen beinhalten,
n) wobei die zweiten Erdungskontaktabschnitte (70) wenigstens zum Teil entlang der Befestigungsseite des Gehäuses freiliegen und mit entsprechenden Erdungskontakten (96) des elektrischen Gegenstands (86) in Eingriff bringbar sind;
o) wodurch der Verbinder eine sicher bestimmte Erdungsverbindung in Zuordnung mit jeder Signalverbindung an jeder Stelle der Signalkontaktpaare sowie zwischen den Signalkontaktelementen des jeweiligen Paares besitzt,
**dadurch gekennzeichnet**,
p) daß es sich bei jedem Erdungskontaktelement (54) um ein im wesentlichen planares Element handelt und dieses einen Körperabschnitt (61) aufweist, der sich von einer ersten zu einer zweiten Seitenkante erstreckt, wobei sich das Paar der einander gegenüberliegenden freitragenden Arme (60) in der Nähe der ersten und der zweiten Seitenkante von dem Körperabschnitt (61) nach oben erstreckt.

2. Elektrischer Verbinder nach Anspruch 1,
wobei die Erdungskontaktabschnitte an den Armen der Erdungskontaktelemente (53) sowohl vertikal als auch horizontal von dem zugeordneten ersten Signalkontaktabschnitt beabstandet sind, wodurch die ersten Signalkontaktabschnitte bei Aufnahme der Karte in dem Kartenaufnahmeschlitz nicht an einer Erdungseinrichtung auf einer Schaltungskarte angreifen, die derart ausgebildet ist, daß sie eine komplementäre, versetzte Anordnung von Signal- und Erdungskontaktflächen aufweist.

3. Verbinder nach Anspruch 2,
wobei nach dem Biegen durch die Schaltungskarte nach dem Einführen derselben in den Kartenaufnahmehohlraum die Distanz zwischen benachbarten Bereichen jedes Paares einander zugeordneter Signal- und Erdungskontaktarme eine ausgewählte, im wesentlichen konstante Distanz ist, die sich in kontinuierlicher Weise zwischen diesen erstreckt, wodurch der induktive Widerstand des Verbinders reduziert ist.

4. Verbinder nach Anspruch 1,
wobei die Breite des Erdungskontakt-Körperabschnitts größer ist als die Breite der in dem Kartenaufnahmehohlraum aufgenommenen Karte.

5. Verbinder nach einem der vorausgehenden Ansprüche,
wobei die Erdungskontaktelemente an einer zentralen Rippe (32) angebracht sind, die sich über die Länge des Gehäuses erstreckt.

6. Verbinder nach einem der vorausgehenden Ansprüche,
wobei das Gehäuse Erdungskontakt-Aufnahmeaussparungen unter der Kartenanschlageinrichtung aufweist, die Passagen beinhalten, in die die Erdungskontaktelemente vom Boden des Gehäuses her eingeführt sind.

## Revendications

1. Connecteur électrique (10) à utiliser avec une carte (72) à circuit du type ayant des moyens de contact de masse (80) disposés le long d'un bord avant et à proximité de celui-ci, et des pistes de signaux ayant des moyens de contact (84) de signaux situés en arrière desdits moyens (80) de masse sur chaque surface principale de la carte (72) à circuit, ledit connecteur (10) comportant :
a) un élément de boîtier diélectrique (12) présentant une face (18) de montage et une face opposée (16) de réception de carte,
b) une cavité (30) de réception de carte s'étendant dans ledit boîtier (12) depuis ladite face (16) de réception de carte jusqu'à un moyen (32) d'arrêt de carte,
c) plusieurs contacts conçus pour s'accoupler avec ladite carte (72) en des emplacements de contact respectifs espacés latéralement le long de ladite cavité (30) et associés à des emplacements de pistes le long de ladite carte (72) à circuit reçue dans ladite cavité (30),
d) des moyens de masse ayant plusieurs éléments de contact (54) de masse pourvus d'une paire de branches opposées (60) en porte-à-faux,
e) ladite pluralité de contact comprenant des éléments de contact (36, 36a) de signaux disposés par paires opposées le long de côtés opposés de ladite cavité (30) de réception de carte, dans chaque emplacement de contact et fixés dans des passages respectifs (26) de réception de contact en communication avec cette cavité (30) de réception de carte,
f) lesdits éléments de contact (36, 36a) de signaux ayant des sections de contact (44) destinées à engager des pistes de signaux opposées respectives sur des surfaces principales opposées de ladite carte (72) lorsque la carte est insérée entre elles,
g) lesdites sections de contact (44) étant définies sur des extrémités libres de branches en porte-à-faux s'étendant à l'intérieur de ladite cavité (30) pour être déviées vers l'extérieur par ladite carte (72) lors de l'insertion de la carte, à la suite de quoi, lesdites sections de contact (44) viennent engager des sections de contact respectives de pistes (84) de signaux lors d'une insertion complète de la carte,
h) lesdits éléments de contact (36, 36a) de signaux ayant des secondes sections de contact (52, 52a) au moins à découvert le long de la face de montage (18) du boîtier (12) et destinées à être accouplées avec des moyens de contact de signaux correspondants (90) d'un autre article électrique (86),
i) ledit boîtier (12) et lesdits éléments de contact (36, 36a) de signaux fixés dans ce boîtier, à chacun desdits emplacements de contact de signaux, étant conçus pour permettre à l'un desdits éléments (54) de contact de masse d'être monté dans ledit boîtier en chacun desdits emplacements de contact de signaux et entre les éléments de l'une, respective, desdites paires d'éléments (36, 36a) de contact de signaux s'y trouvant et qui en sont espacées,
j) lesdites paires de branches opposées (60) en porte-à-faux dudit élément de contact de masse (54) s'étendant vers le haut jusque dans certains, respectifs, desdits passages de réception de contact dans ladite cavité (30) de réception de carte,
k) lesdites paires de branches en porte-à-faux (60) pouvant fléchir dans le plan desdits éléments de contacts de masse sous l'effet de ladite carte lorsqu'elle est insérée dans ladite cavité (30) de réception de carte,
l) lesdites paires de branche (60) en porte-à-faux portant des sections (62) de contacts de masse pouvant être engagées avec certains, respectifs, des moyens de contacts de masse (79) de ladite carte (72) lors d'une insertion complète de la carte,
m) lesdits éléments (54) de contacts de masse comprenant des secondes sections (70) de contact de masse auxdits emplacements de contact,
n) lesdites secondes sections de contacts de masse (70) étant à découvert au moins le long de la face de montage dudit boîtier et pouvant être engagées avec des contacts de masse correspondants (96) dudit article électrique (86) ;
o) grâce à quoi ledit connecteur présente une connexion de masse assurée associée à chaque connexion de signal en chaque emplacement desdites paires de contact de signaux et entre lesdits éléments de contact de signaux de ladite paire respective,
caractérisé en ce que
p) chacun desdits éléments (54) de contacts de masse étant un élément essentiellement plat et comprenant une section de corps (61) s'étendant d'un premier bord latéral à un second bord latéral, ladite paire de branches opposées (60) en porte-à-faux s'étendant vers le haut depuis ladite section de corps (61) à proximité desdits premier et second bords latéraux.

2. Connecteur électrique selon la revendication 1, dans lequel lesdites sections de contact de masse vers lesdites branches desdits éléments de contacts de masse (53) sont espacées à la fois verticalement et horizontalement de la première section de contact de signaux associée ; grâce à quoi
ladite première section de contact de signaux n'engage pas des moyens de masse sur une carte à circuit conçue pour avoir un groupement décalé complémentaire de surface de contact de signaux et de masse lorsque ladite carte est reçue dans ladite fente de réception de carte.

3. Connecteur selon la revendication 1 ou 2, dans lequel, après une déformation par ladite carte à circuit à la suite de son insertion dans ladite cavité de réception de carte, la distance entre des parties adjacentes de chaque paire desdites branches de contacts de masse et de signaux associées est une distance choisie, sensiblement constante, s'étendant en continu entre elles, ce qui diminue l'inductance du connecteur.

4. Connecteur selon la revendication 1, dans lequel la largeur de la section de corps de contact de masse est plus grande que la largeur de la carte reçue dans ladite cavité de réception de carte.

5. Connecteur selon l'une quelconque des revendications précédentes, dans lequel lesdits éléments de contacts de masse sont montés sur une nervure centrale (32) s'étendant sur la longueur du boîtier.

6. Connecteur selon l'une quelconque des revendications précédentes, dans lequel ledit boîtier comprend des évidements de réception de contacts de masse au-dessous desdits moyens d'arrêt de carte, comprenant des passages dans lesquels lesdits éléments de contacts de masse sont insérés depuis le dessous dudit boîtier.
